# EUROPEAN PATENT SPECIFICATION

(11) **EP 2 449 673 B1**
(45) Date of publication and mention of the grant of the patent: **06.03.2013**
(21) Application number: 10738023.0
(22) Date of filing: 28.06.2010
(51) Int. Cl.: H03B 5/12, H03J 3/00

(54) **FINE TUNING OF ELECTRONIC OSCILLATORS**
VERBESSERUNGEN BEI DER FEINEINSTELLUNG VON ELEKTRONISCHEN OSZILLATOREN
AMÉLIORATIONS DU RÉGLAGE FIN D'OSCILLATEURS ÉLECTRONIQUES

(30) Priority: 03.07.2009 GB 0911568
(43) Date of publication of application: 09.05.2012
(73) Proprietor: EoSemi Limited, Congleton Cheshire CW12 4SN (GB)
(72) Inventor: HARROLD, Stephen John, Altrincham WA14 5SE (GB)
(74) Representative: Lambert, Ian Robert
(86) International application number: PCT/GB2010/051062
(87) International publication number: WO 2011/001168

(56) References cited:
- EP-A1- 1 143 606
- US-A1- 2003 231 039

## Description

This invention relates to improvements in the fine tuning of electronic oscillators, with reference to a method of producing an output signal having an output frequency, and to an electronic oscillator for producing an output signal having an output frequency.

Electronic oscillators are important and fundamental components of a wide range of electrical devices. It is of course a desired aim that the output frequency of an electronic oscillator is of high precision. There is an ongoing need to fine tune the frequency of electronic oscillators to compensate for deviations in the output frequency caused by manufacturing tolerances and changes in the operating environment such as fluctuations in supply voltage and temperature. It is well known to achieve such compensation by controlling the value of one or more capacitors in the oscillator circuit. This control is achieved by using switches to vary the quantity of capacitances connected to the oscillator circuit. By using a "tuning" mechanism to adjust component values, it is possible to achieve a desired oscillation frequency. This is commonly achieved by connecting or disconnecting parallel and/or series elements in an integrated circuit. In such arrangements, the frequency tuning is not continuous, but rather consists of a series of discrete frequencies separated by frequency "steps". It is desirable that the size of the frequency steps is minimised; however, the frequency step size is limited by errors in the matching of the circuit elements. It is difficult to produce very small capacitances reliably, and switches will have an associated capacitance which will be present even when the associated capacitor is disconnected. Furthermore, the extent of the mismatch between nominally identical capacitors increases as the capacitances decreases. These factors impose a lower limit on the achievable minimum frequency step.

A well known solution to overcome these limitations on the minimum capacitance/frequency step is the technique of "dithering", wherein the oscillation frequency varies between two or more separate frequency values. Typically, the connection of a reasonably-valued capacitance is dithered, so that the capacitance is only connected to the oscillator for a defined fraction of the time that the oscillator is in use. In this way, when averaged over time, the capacitor acts as if it has a smaller capacitance, with this value being dependent upon the proportion of time it is connected (referred to here as the "dither-fraction"). This results in a frequency step size which is determined by the precision of control of the dither-fraction rather than by the minimum sized capacitor.

Typically, dithering is carried out at a lower frequency than the oscillation frequency i.e., the additional capacitance will be connected over some oscillator cycles and be disconnected over other oscillator cycles. An advantage associated with this approach is that the effective capacitance is linearly dependent on the dither-fraction. When compensating for the effect of environmental changes, such as temperature fluctuations, it is common to determine control codes which are required to correct the frequency at a few calibration points, and to calculate the necessary control codes for other conditions by interpolation and extrapolation. It is highly advantageous if a linear relationship between effective capacitances and dither-fraction is achieved, in order to allow the necessary calculations to be performed easily and to permit convenient and accurate frequency compensation.

However, dithering at a lower frequency than the oscillation frequency gives rise to cycle-to-cycle period variations as the additional capacitance is connected or disconnected. The associated output waveforms have additional frequency components on either side of the oscillation frequency, and a waveform period which is not constant in every cycle. This gives rise to cycle-to-cycle variations, i.e., jitter, which is equal to the difference between the periods of the separate, discrete frequencies which the technique dithers between. In oscillators having a high Q-factor such as a crystal oscillator, the high Q provides the system with some "inertia" which reduces the jitter to some extent, but will not eliminate it. Oscillators with a medium or low Q-factor are even more susceptible to jitter of this type.

EP 1793488, US 2007/024379 and our own earlier International patent publication number WO 2009/056835 propose a solution to the problem of jitter in which the oscillator is run at a frequency which is higher than the desired output frequency. A frequency divider is used to derive a single frequency, non-varying output with low jitter. However, this technique suffers from an undesirably high power consumption which is associated with the higher oscillation frequency. It is thus desirable for the oscillator to operate at the target frequency. However, as discussed above, dithering techniques which hitherto use an oscillator operating at the target frequency suffer from the problem of cycle-to-cycle jitter.

US 2003/0231039 discloses an apparatus for continuous variable reactive impedance control wherein a reactive component such as a capacitor is switched into the oscillating cycle of an oscillating circuit for a duration at the beginning and end of each half cycle of the oscillation frequency. The oscillation frequency is varied by varying this duration period. EP 1143606 discloses an oscillator in which dithering is performed by switching one or more capacitors into the oscillator. The configuration is only changed once per oscillation cycle.

The present invention, in at least some of its embodiments, addresses the aforementioned problems.

According to a first aspect of the invention there is provided a method of providing an output signal including the steps of:
providing an electronic oscillator having a switching arrangement allowing the oscillator to be switched between at least a first configuration having an associated first oscillator frequency and period, and a second configuration having an associated second oscillator frequency and period, and a control arrangement for controlling the switching arrangement; and
dithering the oscillator between at least the first configuration and the second configuration to produce the output signal having an intermediate frequency and period, in which dithering is performed by switching from the first configuration to the second configuration for a pre-determined subset of each output signal period over successive cycles of the output signal frequency, and the switching from the first configuration to the second configuration for the pre-determined subset of each output signal period is pulsed so that a plurality of pulses are produced during each output signal period over successive cycles of the output signal, wherein the oscillator is in the second configuration during the course of each pulse; there being an even number of pulses produced during each output signal period;
in which: the dithering is variable so as to alter or correct the frequency of the output signal; the frequency of the output signal has an associated output signal waveform; and each pulse has an associated pulse characteristic which includes a turn on time within the period of the output signal frequency wherein the oscillator is switched from the first configuration to the second configuration and a turn-off time within the period of the output signal frequency wherein the oscillator is switched from the second configuration to the first configuration;
wherein variation of the dithering to alter or correct said output frequency is performed by altering the pulse characteristics of at least some of the pulses within each period of the output signal frequency so that the turn-on time and/or turn-off time of at least one pulse is shifted towards a peak in the rate of change of the output signal waveform and the turn-on time and/or turn off time of at least one other pulse is shifted towards a minimum in the rate of change of the output signal waveform thereby improving the linearity of the output frequency with respect to the variation of the dithering.

In this way, the dithering is carried out at a higher frequency than the output frequency, for example by connecting a capacitance for a defined fraction (the "dither-fraction") of every period of the output signal. Advantageously, the method of the invention allows dithering to be performed without suffering from large jitter.

It is desirable that the tuning curve of the electronic oscillator is substantially linear, or at least that non-linearity is reduced. The term "tuning characteristic" refers to the dependence of the effective capacitance and/or output frequency on the dither-fraction. Embodiments of the invention which give rise to reductions in the non-linearity of the tuning characteristic are described below.

Dithering is carried out at a higher frequency than the output frequency. Preferably, the switching from the first configuration to the second configuration for the pre-determined subset of each output signal period is pulsed so that a plurality of pulses are produced during each output signal period over successive cycles of the output signal frequency, wherein the oscillator is in the second configuration during the course of each pulse. In order to reduce nonlinearities in the tuning characteristic, an even number of pulses are produced during each output signal period. Advantageously, at least four pulses are produced during each output signal period, preferably at least eight.

Advantageously, the plurality of pulses are substantially evenly spaced within each output signal period.

The plurality of pulses may be substantially evenly spaced in time. With sinusoidal output signals, it is preferred that the plurality of pulses are substantially evenly spaced within each output signal period and substantially evenly spaced in time, With output signals having a different waveform, a different approach may be used; for example, the plurality of pulses may be substantially evenly spaced within each output signal period, but not substantially evenly spaced in time.

The present inventors have recognised that the output signal frequency is dependent both on the dither-fraction and the phase of the oscillator waveform when the oscillator is switched between the first and second configurations. This is because the opening and closing of the switching arrangement will introduce some electrical noise which produces a change in the oscillator phase. The amount of change of oscillator phase that occurs is dependent on the rate of change of the output signal waveform at the instant at which switching occurs and electrical noise is produced. More particularly, noise which occurs in a region of low rate of change of the output signal waveform (for example, near the peaks of a sinusoidal oscillator waveform) will have a relatively small effect, whilst noise occurring in a region of high rate of change of the waveform (for example, near the mid-points of a sinusoidal oscillator waveform) will have a greater effect.

In the invention, the pulses are produced so that tuning of the pulses results in some noise producing events (i.e., turn-ons and/or turn-offs) occurring closer to a peak in the rate of change of the output signal waveform, and other noise producing events occurring closer to a minimum in the rate of change of the output signal waveform, with the variations being arranged to substantially cancel each other out in terms of the effect of the electrical noise on the output signal frequency. Conveniently, this can be achieved by using an even number of four or more pulses which are substantially evenly spaced within each output signal period. Conveniently, the pulse characteristics of the pulses are altered by shifting the turn-off times, although it would also be possible to shift the turn-on times or to shift both the turn-on times and turn-off times. From a control point of view, it is convenient if the pulses are all shifted by the same extent; however, the skilled reader will appreciate that other, more complicated pulse shifting methodologies might be employed.

It is preferred that switching is performed using a pulse width modulated (PWM) signal to control the switching arrangement. However, switching may be performed using other techniques, such as by using a delta-sigma modulated signal, to control the switching arrangement.

Typically, although not exclusively, the oscillator is a programmable oscillator such as a RC oscillator. However, the invention extends also to non-programmable oscillators.

Typically, but not exclusively, the output signal is a sinusoidal waveform. However, the invention is applicable to the production of other waveform shapes.

The pulses may be produced digitally or using analogue control.

The switching of the oscillator between the first and second configurations can be achieved using one of a number of techniques which are well known in the art, or a combination of techniques. For example, an electrical element such as a capacitor, resistor or an inductor may be switched into and out of connection to the oscillator. In other embodiments, current or voltage switching may be employed, for example by varying the output of a supply source, or by I switching an array of supply sources.

According to a second aspect of the invention there is provided an electronic oscillator for producing an output signal, including:
a switching arrangement allowing the oscillator to be switched between at least a first configuration having an associated first oscillator frequency and period, and a second configuration having an associated second oscillator frequency and period; and
a control arrangement for controlling the switching arrangement so that the oscillator is dithered between at least the first configuration and the second configuration to produce the output signal having an intermediate frequency and period, in which dithering is performed by switching from the first configuration to the second configuration for a pre-determined subset of each output signal period over successive cycles of the output signal frequency, and the switching from the first configuration to the second configuration for the pre-determined subset of each output signal period is pulsed so that a plurality of pulses are produced during each output signal period over successive cycles of the output signal, wherein the oscillator is in the second configuration during the course of each pulse, there being an even number of pulses produced during each output signal period;
in which: the dithering is variable so as to alter or correct the frequency of the output signal; the frequency of the output signal has an associated output signal waveform; and each pulse has an associated pulse characteristic which includes a turn-on time within the period of the output signal frequency wherein the oscillator is switched from the first configuration to the second configuration and a turn-off time within the period of the output signal frequency wherein the oscillator is switched from the second configuration to the first configuration;
wherein variation of the dithering to alter or correct said output frequency is performed by altering the pulse characteristics of at least some of the pulses within each period of the output signal frequency so that the turn-on time and/or turn-off time of at least one pulse is shifted towards a peak in the rate of change of the output signal waveform and the turn-on time and/or turn off time of at least one other pulse is shifted towards a minimum in the rate of change of the output signal waveform thereby improving the linearity of the output frequency with respect to the variation of the dithering.

The second aspect of the invention can incorporate any feature described above in relation to the first aspect of the invention.

Whilst the invention has been described above, it extends to any inventive combination as set out above or in the following description, drawings or claims.

Embodiments of electronic oscillators and methods in accordance with the invention will now be described with reference to the accompanying drawings, in which:-
Figure 1 is a schematic diagram showing an electronic oscillator of the invention;
Figure 2 shows (a) output signal and (b) dither control signals for an oscillator using one dither signal per cycle;
Figure 3 shows the frequency tuning characteristic of the oscillator associated with Figure 2;
Figure 4 shows output signal and dither control signals for an oscillator in which the dither control signal comprises four evenly spaced pulses per output cycle; and
Figure 5 shows the frequency tuning characteristic for the oscillator associated with Figure 4.

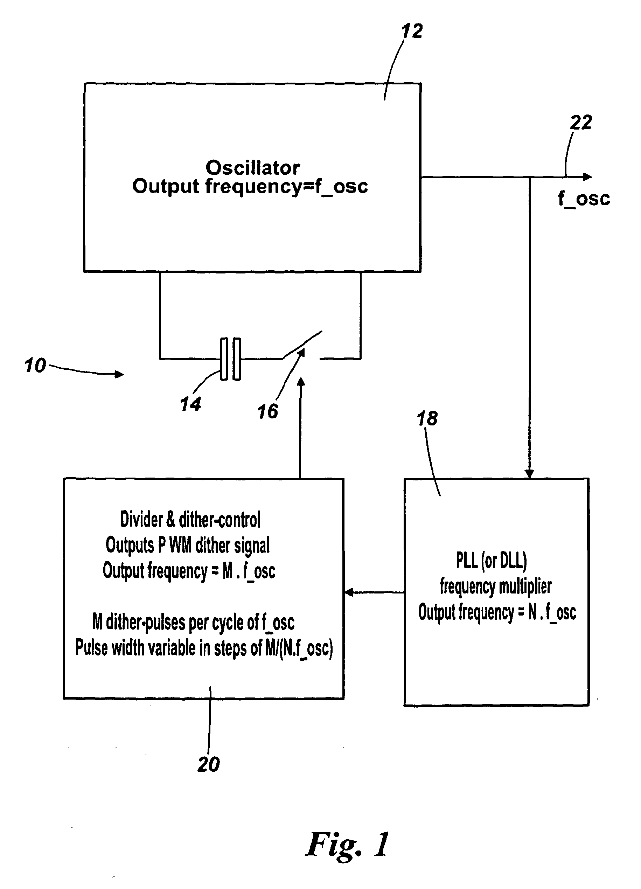

Figure 1 is a schematic diagram of an electronic oscillator, shown generally at 10, of the invention. The electronic oscillator 10 comprises an oscillator 12 having a capacitor 14 which can be switched into and out of connection with the remainder of the oscillator by a switching arrangement 16. In this way, the output frequency of the oscillator 10 can be varied by way of opening and closing the switching arrangement 16. The electronic oscillator 10 further comprises a frequency multiplier 18, such as a phase locked loop (PLL) or delay lock loop (DLL) frequency multiplier. The frequency multiplier 18 produces an output frequency N.f_osc, where f_osc is the output frequency of the electronic oscillator, and N is greater than 1. The output frequency of the frequency multiplier is input into a control arrangement 20. The control arrangement 20 outputs M dither pulses per cycle of the output signal of frequency f_osc where M is an integer of 1 or greater, and is preferably 2 or greater, and more preferably 4 or greater. The dither pulses are of a pulse width which is variable in steps of M/(N.f_osc). It will be appreciated that the output frequency of the dither control pulses produced by the control arrangement 20 is M.f_osc and that the frequency of the dithering is necessarily higher than the output f_osc. The dither control pulses output by the control arrangement 20 are sent to the switching arrangement 16 in order to control the dithering of the capacitance 14 so as to control the output frequency f_osc which is output from the oscillator 12 at 22.

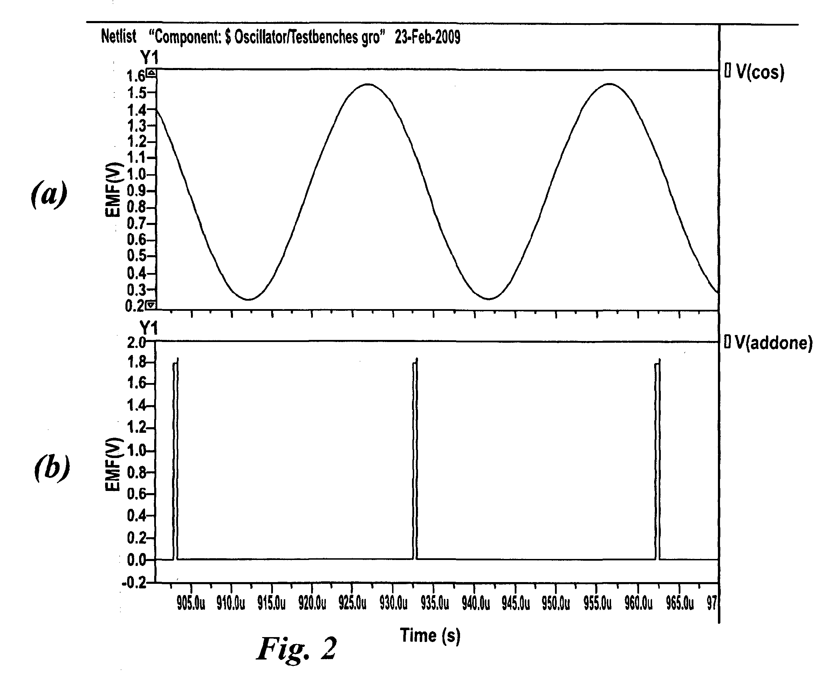

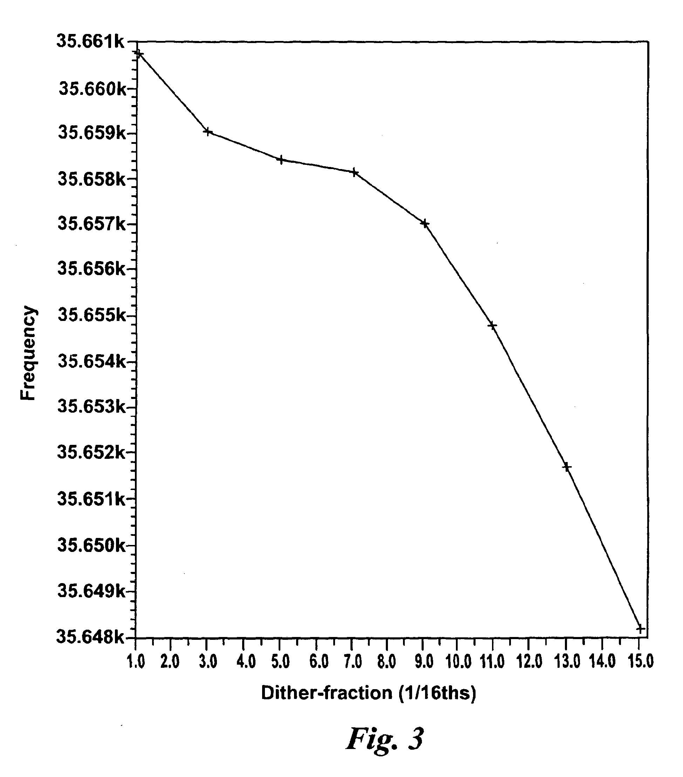

Figure 2 shows (a) the output signal and (b) the dither control signals for an oscillator which uses a pulse-width modulated dither signal to vary the oscillator frequency. In this example, the switching turn-on time is constant in every cycle, but the turn-off time varies in line with changes in the pulse width as the dither-fraction varies. Figure 3 shows the associated frequency tuning characteristic as a graph of output frequency against the dither-fraction. It can be seen from Figure 3 that the frequency tuning characteristic exhibits nonlinearities, which is undesirable from the point of view of correcting the output frequency in response to fluctuations in environmental conditions such as temperature. However, the dither control methodology which is associated with Figures 2 and 3 has the advantages that jitter is greatly reduced when the pulse width remains constant in comparison with techniques where the dithering is at a lower frequency than the oscillator frequency, and the power consumption is reduced in comparison to techniques in which the oscillator is operated at a frequency which is considerably higher than the desired output frequency.

The present inventors have realised that each transition of the control signal will introduce switching noise into the oscillator, and this produces a change in instantaneous phase of the waveform, i.e., a change in the frequency and period of the output. If the dithering pulses occur at the same points in every oscillator cycle then the effect will be a consistent change in the oscillator period, i.e., no dither-induced jitter. However, if the width or number of control signals changes, then a variable change in the oscillator period can result, and the present inventors have appreciated that this gives rise to the non-linear frequency tuning characteristic shown in Figure 3. Furthermore, the present inventors have realised that the output frequency is dependent both on the dither-fraction and the phase of the oscillator waveform when connection and disconnection occurs. The opening and closing of the switching arrangement 16 introduces some electrical noise which will produce a change in the oscillator phase in addition to the change in phase produced by the change in capacitance. Furthermore, the amount of phase change introduced is dependent on the rate of change of the output waveform at the instant at which the electrical noise is introduced. The impact of this is that electrical noise caused by switching which occurs near regions of low rate of change of the waveform (i.e., near the peaks of a sinusoidal waveform) will have minimal effect on the oscillator phase. However, noise occurring due to switching near to regions of high rate of change of the waveform (i.e., near the mid-points of sinusoidal waveform) will cause a greater change in the oscillator phase. The theoretical explanation of this phenomenon has been described by A Hajimiri and T H Lee, IEEE.Solid-State Circuits, 33 (2) 1998 179-194 and 33(6) 1998 928. For the avoidance of doubt, the term "waveform peaks" includes both the maximum (upper) peak and minimum (lower) peak occurring within a waveform cycle. In the context of the present invention, changing the dither-fraction changes the time at which switching occurs, and thereby changes the effect on the oscillator phase, introducing non-linearity into the relationship between dither-fraction and output frequency. This degrades the tuning resolution, and can introduce errors if control codes are generated by interpolation or extrapolation in order to correct the changes in the output frequency due to fluctuations in the operating environment.

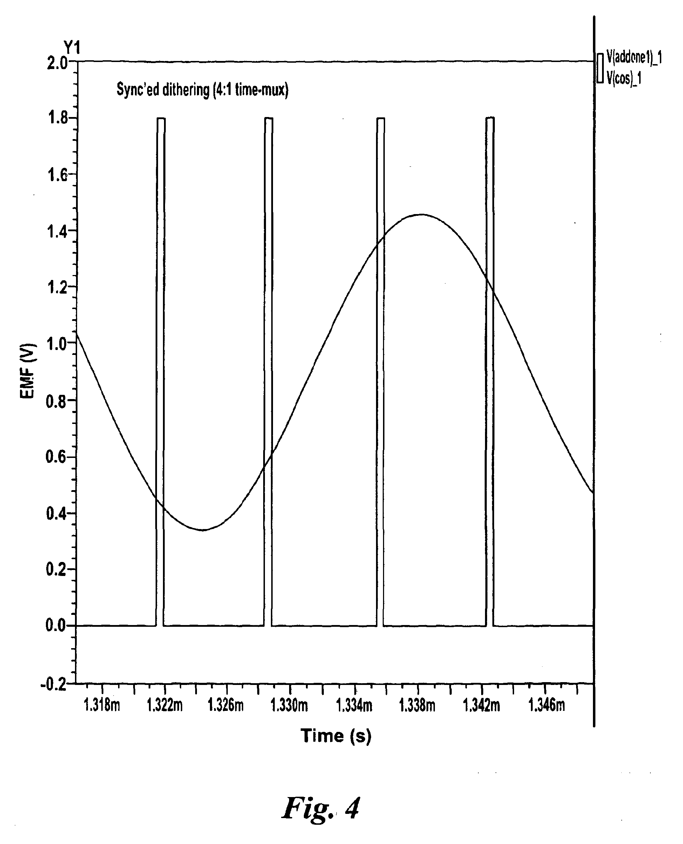

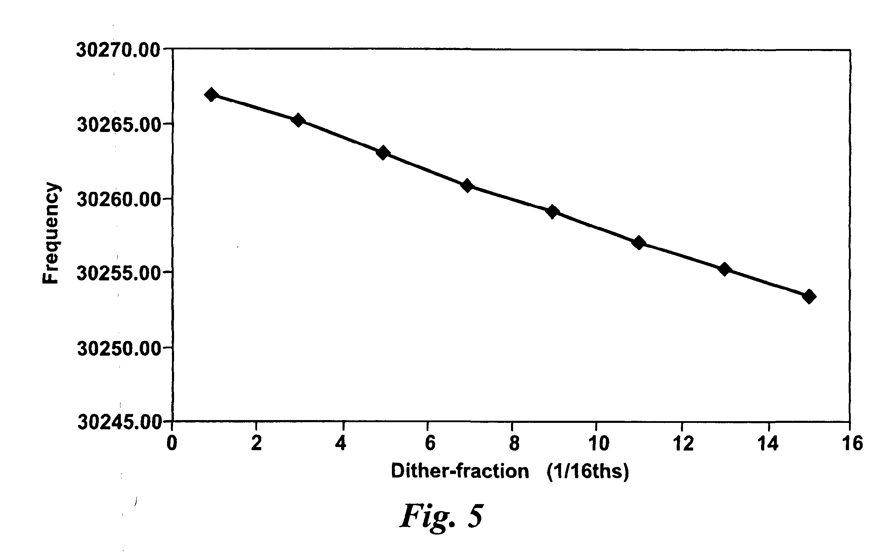

Figure 4 shows an example of a control methodology in accordance with the invention which results in significant improvements in the frequency tuning characteristic. As can be seen in Figure 4, four evenly spaced dither control signal pulses are utilised within each cycle of the output waveform to control the switching arrangement 16. In other words, the PWM dither-pulse is time multiplexed 4:1 through the oscillator period. In this example, the turn-on times are fixed in each cycle, but the turn-off times vary with pulse width and dither-fraction. The time-multiplexing means that increasing the dither-fraction results in two of the falling pulse edges associated with turn-off moving towards the peaks in the rate of change of the oscillator waveform, with the other two falling edges moving towards the minima in the rate of change of the waveform. The shift towards the peaks in the rate of change of the oscillator waveform increase the sensitivity of the output frequency to the associated switching noise, whilst the shifting of the edges towards the minima in the rate of change of the oscillator waveform (i.e., the waveform mid-points) decreases the sensitivity of the oscillator phase change to the associated switching noise. The combined effect is that the variations in the phase caused by switching noise associated with the turn-off times are greatly reduced. The associated frequency tuning characteristic is shown in Figure 5, from which it can be seen that a highly linear and therefore highly advantageous response is obtained.

It should be noted that the linear response characteristic shown in Figure 5 is obtained because the combined effect of the switching noise from the turn-on and turn-off events is constant. It follows that a dither pulse must always be present, and so the dither-fraction cannot be reduced to zero unless on and off switching noise cancels exactly. If a 4-bit PWM scheme is used to control the dither-fraction, the dither-fraction will vary in 1/16^{th} increments, but in order to obtain a linear response, the 0/16^{th} step should not be used. This can be achieved by restricting the dither-fraction to have a range from 1/16^{th} to 15/16^{th} witth1/8^{th} steps, which effectively reduces the PWM resolution to 3-bits in order to obtain an improved degree of linearity in the frequency tuning characteristic.

A linear response can also be obtained by arranging for the timings of the dither pulse turn-on to be shifted instead of shifting the turn-off timings. Alternatively, the turn-on and turn-off timings can both be shifted, with the turn-on timings being shifted in the opposite direction to the turn-off timings as the pulse width and dither-fraction is varied.

The device shown in Figure 1 can be adapted to implement the methodologies described in relation to Figures 2 to 5. Typically, the switching arrangement is used to switch a single capacitance into and out of connection with the oscillator. However, other, possibly more complicated, arrangements in which the oscillator frequency is changed by way of a switching arrangement might be envisaged. In MOS integrated circuits, transistors will typically be used as active elements of the switching arrangement. Other arrangements, using one or more switches, would occur regularly to the skilled reader. It is convenient to utilise pulse width modulation to produce control pulses which control the switching of the switching arrangements. However, other control methodologies, such as the use of sigma-delta modulation schemes with high over-sampling ratios, may also be used with the same advantage.

The example has used an oscillator giving a sinusoidal output waveform. It should be noted that this not an essential requirement, and the invention may be used to produce other output waveforms with similar advantage.

## Claims

1. A method of producing an output signal including the steps of:
providing an electronic oscillator (10) having a switching arrangement (16) allowing the oscillator to be switched between at least a first configuration having an associated first oscillator frequency and period, and a second configuration having an associated second oscillator frequency and period, and a control arrangement (20) for controlling the switching arrangement; and
dithering the oscillator between at least the first configuration and the second configuration to produce the output signal, having an intermediate frequency and period, in which the dithering is performed by switching from the first configuration to the second configuration for a pre-determined subset of each output signal period over successive cycles of the output signal frequency, and the switching from the first configuration to the second configuration for the pre-determined subset of each output signal period is pulsed so that a plurality of pulses are produced during each output signal period over successive cycles of the output signal, wherein the oscillator is in the second configuration during the course of each pulse; there being an even number of pulses produced during each output signal period;
in which: the dithering is variable so as to alter or correct the frequency of the output signal; the frequency of the output signal has an associated output signal waveform; and each pulse has an associated pulse characteristic which includes a turn-on time within the period of the output signal frequency wherein the oscillator is switched from the first configuration to the second configuration and a turn-off time within the period of the output signal frequency wherein the oscillator is switched from the second configuration to the first configuration;
wherein variation of the dithering to alter or correct said output frequency is performed by altering the pulse characteristics of at least some of the pulses within each period of the output signal frequency so that the turn-on time and/or turn-off time of at least one pulse is shifted towards a peak in the rate of change of the output signal waveform and the turn-on time and/or turn off time of at least one other pulse is shifted towards a minimum in the rate of change of the output signal waveform thereby improving the linearity of the output frequency with respect to the variation of the dithering.

2. A method according to claim 1 in which at least four pulses are produced during each output signal period.

3. A method according to claim 1 or claim 2 in which the plurality of pulses are substantially evenly spaced within each output signal period.

4. A method according to any one of claims 1 to 3 in which the plurality of pulses are substantival evenly spaced in time.

5. A method of producing an output signal having an output frequency according to any previous claim in which switching is performed using a pulse width modulated signal to control the switching arrangement.

6. A method of producing an output signal having an output frequency according to any one of claims 1 to 5 in which switching is performed using a delta-sigma modulated signal to control the switching arrangement.

7. An electronic oscillator (10) for producing an output signal, including:
a switching arrangement (16) allowing the oscillator to be switched between at least a first configuration having an associated first oscillator frequency and period, and a second configuration having an associated second oscillator frequency and period; and
a control arrangement (20) for controlling the switching arrangement so that the oscillator is dithered between at least the first configuration and the second configuration to produce the output signal having an intermediate frequency and period, in which dithering is performed by switching from the first configuration to the second configuration for a pre-determined subset of each output signal period over successive cycles of the output signal frequency, and the switching from the first configuration to the second configuration for the pre-determined subset of each output signal period is pulsed so that a plurality of pulses are produced during each output signal period over successive cycles of the output signal , wherein the oscillator is in the second configuration during the course of each pulse, there being an even number of pulses produced during each output signal period;
in which: the dithering is variable so as to alter or correct the frequency of the output signal; the frequency of the output signal has an associated output signal waveform; and each pulse has an associated pulse characteristic which includes a turn-on time within the period of the output signal frequency wherein the oscillator is switched from the first configuration to the second configuration and a turn-off time within the period of the output signal frequency wherein the oscillator is switched from the second configuration to the first configuration;
wherein variation of the dithering to alter or correct said output frequency is performed by altering the pulse characteristics of at least some of the pulses within each period of the output signal frequency so that the turn-on time and/or turn-off time of at least one pulse is shifted towards a peak in the rate of change of the output signal waveform and the turn-on time and/or turn off time of at least one other pulse is shifted towards a minimum in the rate of change of the output signal waveform thereby improving the linearity of the output frequency with respect to the variation of the dithering.

## Patentansprüche

1. Verfahren zur Erzeugung eines Ausgangssignals, umfassend die folgenden Schritte: Schaffung eines elektronischen Oszillators (10) mit einer Schaltanordnung (16), die dem Oszillator ermöglicht, zwischen wenigstens einer ersten Konfiguration mit einer zugeordneten ersten Oszillatorfrequenz und Periode und einer zweiten Konfiguration geschaltet zu werden, die eine zugeordnete zweite Oszillatorfrequenz und Periode aufweist, und mit einer Steueranordnung (20) zur Steuerung der Schaltanordnung; und Ausgleichsmodulieren des Oszillators zwischen wenigstens der ersten Konfiguration und der zweiten Konfiguration zur Erzeugung des Ausgangssignals mit einer mittleren Frequenz und Periode, in der das Ausgleichsmodulieren durch Schalten von der ersten Konfiguration zu der zweiten Konfiguration für einen vorbestimmten Teilnehmer jeder Ausgangssignalperiode über aufeinanderfolgende Zyklen der Ausgangssignalfrequenz durchgeführt wird, wobei das Schalten von der ersten Konfiguration zu der zweiten Konfiguration für einen vorbestimmten Teilnehmer jeder Ausgangssignalperiode so gepulst wird, daß eine Vielzahl von Impulsen während jeder Ausgangssignalperiode über aufeinanderfolgende Zyklen des Ausgangssignals erzeugt wird, wobei ferner der Oszillator während des Laufs jedes Impulses sich in der zweiten Konfiguration befindet und während jeder Ausgangssignalperiode eine gerade Anzahl Impulse erzeugt wird; **dadurch gekennzeichnet, daß** das Ausgleichsmodulieren variabel ist, um auf diese Weise die Frequenz des Ausgangssignals zu ändern oder zu korrigieren, daß die Frequenz des Ausgangssignals eine zugehörige Ausgangssignal-Wellenform aufweist und jeder Impuls eine zugeordnete Impulscharakteristik, die innerhalb der Periode der Ausgangssignalfrequenz eine Einschaltzeit besitzt, in der der Oszillator von der ersten Konfiguration in die zweite Konfiguration geschaltet wird, sowie eine Ausschaltzeit in der Periode der Ausgangssignalfrequenz, in der der Oszillator aus der zweiten Konfiguration in die erste Konfiguration geschaltet wird; wobei Änderungen des Ausgleichsmodulierens als Änderung oder Korrektur der Ausgangsfrequenz durch Ändern der Impulskennzeichen von wenigstens einigen der Impulse durchgeführt werden, und zwar in jeder Periode der Ausgangssignalfrequenz, so daß die Einschaltzeit und / oder die Ausschaltzeit wenigstens eines Impulses innerhalb der Änderungsrate der Ausgangssignal-Wellenform in Richtung auf eine Spitze verschoben wird und die Einschaltzeit und / oder die Ausschaltzeit wenigstens eines anderen Impulses in der Änderungsrate der Ausgangssignal-Wellenform gegen ein Minimum verschoben wird, um dadurch die Linearität der Ausgangsfrequenz in Bezug auf die Änderung der Ausgleichsmodulierung zu verbessern.

2. Verfahren nach Anspruch 1, **dadurch gekennzeichnet, daß** wenigstens vier Impulse während jeder Ausgangssignalperiode erzeugt werden.

3. Verfahren nach Anspruch 1 oder 2, **dadurch gekennzeichnet, daß** die vielen Impulse in jeder Ausgangssignalperiode im wesentlichen gleichmäßig beabstandet sind.

4. Verfahren nach einem der Ansprüche 1 bis 3, **dadurch gekennzeichnet, daß** die vielen Impulse innerhalb der Zeit im wesentlichen gleichmäßig beabstandet sind.

5. Verfahren zur Erzeugung eines Ausgangssignals, das eine Ausgangsfrequenz aufweist, nach einem der vorhergehenden Ansprüche, **dadurch gekennzeichnet, daß** das Schalten durch Benutzen eines impulsweiten-modulierten Signals durchgeführt wird, um dadurch die Schaltanordnung zu steuern.

6. Verfahren zur Erzeugung eines Ausgangssignals mit einer Ausgangsfrequenz gemäß einem der Ansprüche 1 bis 5, **dadurch gekennzeichnet, daß** das Schalten unter Verwendung eines Delta-Sigmamodulierten Signals erfolgt, um die Schaltanordnung zu steuern.

7. Elektronischer Oszillator (10) zur Erzeugung eines Ausgangssignals, aufweisend die folgenden Teile: eine Schaltanordnung (16), die dem Oszillator ermöglicht, zwischen wenigstens einer ersten Konfiguration mit einer zugeordneten ersten Oszillatorfrequenz und Periode und einer zweiten Konfiguration geschaltet zu werden, die eine zugeordnete zweite Oszillatorfrequenz und Periode aufweist, und mit einer Steueranordnung (20) zur Steuerung der Schaltanordnung; und Ausgleichsmodulieren des Oszillators zwischen wenigstens der ersten Konfiguration und der zweiten Konfiguration zur Erzeugung des Ausgangssignals mit einer mittleren Frequenz und Periode, in der das Ausgleichsmodulieren durch Schalten von der ersten Konfiguration zu der zweiten Konfiguration für einen vorbestimmten Teilnehmer jeder Ausgangssignalperiode über aufeinanderfolgende Zyklen der Ausgangssignalfrequenz durchgeführt wird, wobei das Schalten von der ersten Konfiguration zu der zweiten Konfiguration für einen vorbestimmten Teilnehmer jeder Ausgangssignalperiode so gepulst wird, daß eine Vielzahl von Impulsen während jeder Ausgangssignalperiode über aufeinanderfolgende Zyklen des Ausgangssignals erzeugt wird, wobei ferner der Oszillator während des Laufs jedes Impulses sich in der zweiten Konfiguration befindet und während jeder Ausgangssignalperiode eine gerade Anzahl Impulse erzeugt wird; **dadurch gekennzeichnet, daß** das Ausgleichsmodulieren variabel ist, um auf diese Weise die Frequenz des Ausgangssignals zu ändern oder zu korrigieren, daß die Frequenz des Ausgangssignals eine zugehörige Ausgangssignal-Wellenform aufweist und jeder Impuls eine zugeordnete Impulscharakteristik, die innerhalb der Periode der Ausgangssignalfrequenz eine Einschaltzeit besitzt, in der der Oszillator von der ersten Konfiguration in die zweite Konfiguration geschaltet wird, sowie eine Ausschaltzeit in der Periode der Ausgangssignalfrequenz, in der der Oszillator aus der zweiten Konfiguration in die erste Konfiguration geschaltet wird; wobei Änderungen des Ausgleichsmodulierens als Änderung oder Korrektur der Ausgangsfrequenz modulierens als Änderung oder Korrektur der Ausgangsfrequenz durch Ändern der Impulskennzeichen von wenigstens einigen der Impulse durchgeführt werden, und zwar in jeder Periode der Ausgangssignalfrequenz, so daß die Einschaltzeit und / oder die Ausschaltzeit wenigstens eines Impulses innerhalb der Änderungsrate der Ausgangssignal-Wellenform in Richtung auf eine Spitze verschoben wird und die Einschaltzeit und / oder die Ausschaltzeit wenigstens eines anderen Impulses in der Änderungsrate der Ausgangssignal-Wellenform gegen ein Minimum verschoben wird, um dadurch die Linearität der Ausgangsfrequenz in Bezug auf die Änderung der Ausgleichsmodulierung zu verbessern.

## Revendications

1. Procédé de production d'un signal de sortie qui comprend les étapes qui consistent à :
prévoir un oscillateur électronique (10) ayant un système de commutation (16) qui permet audit oscillateur de basculer entre au moins une première configuration ayant une première fréquence et période d'oscillation associée, et une seconde configuration ayant une seconde fréquence et période d'oscillation associée, et un système de contrôle (20) destiné à contrôler ledit système de commutation ; et
faire basculer ledit oscillateur entre au moins ladite première configuration et ladite seconde configuration afin de produire ledit signal de sortie, ayant une fréquence et une période intermédiaire, ledit basculement étant effectué en passant de ladite première configuration à ladite seconde configuration pendant un sous-ensemble prédéterminé de chaque période dudit signal de sortie sur des cycles successifs de la fréquence dudit signal de sortie, et le passage de ladite première configuration à ladite seconde configuration pendant ledit sous-ensemble prédéterminé de chaque période dudit signal de sortie est pulsé de sorte que plusieurs impulsions soient produites pendant chaque période dudit signal de sortie sur des cycles successifs dudit signal de sortie, ledit oscillateur étant dans ladite seconde configuration pendant chaque impulsion, et un nombre pair d'impulsions étant produit pendant chaque période dudit signal de sortie ;
dans lequel : ledit basculement est variable de façon à modifier ou à corriger la fréquence dudit signal de sortie ; la fréquence dudit signal de sortie possède une forme d'onde de signal de sortie associée ; et chaque impulsion possède une caractéristique d'impulsion associée qui comprend une durée d'activation pendant la période de fréquence dudit signal de sortie au cours de laquelle l'oscillateur passe de ladite première configuration à ladite seconde configuration, et une durée de désactivation pendant la période de fréquence dudit signal de sortie au cours de laquelle ledit oscillateur passe de ladite seconde configuration à ladite première configuration ;
dans lequel la variation du basculement afin de modifier ou de corriger ladite fréquence de sortie est effectuée en modifiant les caractéristiques d'au moins certaines des impulsions au cours de chaque période de fréquence dudit signal de sortie afin que ladite durée d'activation et/ou ladite durée de désactivation d'au moins une impulsion se décale vers un pic de vitesse de changement de ladite forme d'onde du signal de sortie, et que la durée d'activation et/ou la durée de désactivation d'au moins une autre impulsion se décale vers une vitesse de changement minimum de ladite forme d'onde du signal de sortie, améliorant ainsi la linéarité de la fréquence de sortie par rapport à la variation dudit basculement.

2. Procédé selon la revendication 1, dans lequel au moins quatre impulsions sont produites pendant chaque période dudit signal de sortie.

3. Procédé selon la revendication 1 ou 2, dans lequel lesdites impulsions sont espacées de manière sensiblement régulière au sein de chaque période dudit signal de sortie.

4. Procédé selon l'une quelconque des revendications 1 à 3, dans lequel lesdites impulsions sont espacées de manière sensiblement régulière dans le temps.

5. Procédé de production d'un signal de sortie ayant une fréquence de sortie selon l'une quelconque des revendications précédentes, dans lequel ladite commutation est effectuée en utilisant un signal à modulation de durée d'impulsion afin de contrôler ledit système de commutation.

6. Procédé de production d'un signal de sortie ayant une fréquence de sortie selon l'une quelconque des revendications 1 à 5, dans lequel ladite commutation est effectuée en utilisant un signal modulé delta-sigma afin de contrôler ledit système de commutation.

7. Oscillateur électronique (10) destiné à produire un signal de sortie, qui comprend :
un système de commutation (16) qui permet audit oscillateur de basculer entre au moins une première configuration ayant une première fréquence et période d'oscillation associée, et une seconde configuration ayant une seconde fréquence et période d'oscillation associée ; et
un système de contrôle (20) destiné à contrôler ledit système de commutation afin que ledit oscillateur bascule entre au moins ladite première configuration et ladite seconde configuration de façon à produire ledit signal de sortie ayant une fréquence et une période intermédiaire, ledit basculement étant effectué en passant de ladite première configuration à ladite seconde configuration pendant un sous-ensemble prédéterminé de chaque période dudit signal de sortie sur des cycles successifs de la fréquence dudit signal de sortie, et le passage de ladite première configuration à ladite seconde configuration pendant ledit sous-ensemble prédéterminé de chaque période dudit signal de sortie est pulsé de sorte que plusieurs impulsions soient produites pendant chaque période dudit signal de sortie sur des cycles successifs dudit signal de sortie, ledit oscillateur étant dans ladite seconde configuration pendant chaque impulsion, et un nombre pair d'impulsions étant produit pendant chaque période dudit signal de sortie ;
dans lequel : ledit basculement est variable de façon à modifier ou à corriger la fréquence dudit signal de sortie ; la fréquence dudit signal de sortie possède une forme d'onde de signal de sortie associée ; et chaque impulsion possède une caractéristique d'impulsion associée qui comprend une durée d'activation pendant la période de fréquence dudit signal de sortie au cours de laquelle l'oscillateur passe de ladite première configuration à ladite seconde configuration, et une durée de désactivation pendant la période de fréquence dudit signal de sortie au cours de laquelle ledit oscillateur passe de ladite seconde configuration à ladite première configuration ;
dans lequel la variation du basculement afin de modifier ou de corriger ladite fréquence de sortie est effectuée en modifiant les caractéristiques d'au moins certaines des impulsions au cours de chaque période de fréquence dudit signal de sortie afin que ladite durée d'activation et/ou ladite durée de désactivation d'au moins une impulsion se décale vers un pic de vitesse de changement de ladite forme d'onde du signal de sortie, et que la durée d'activation et/ou la durée de désactivation d'au moins une autre impulsion se décale vers une vitesse de changement minimum de ladite forme d'onde du signal de sortie, améliorant ainsi la linéarité de la fréquence de sortie par rapport à la variation dudit basculement.
